# EUROPEAN PATENT APPLICATION

(11) **EP 4 299 678 A1**
(43) Date of publication of application: **03.01.2024**
(21) Application number: 22787320.5
(22) Date of filing: 17.03.2022
(51) Int. Cl.: C08L 83/07, C08L 83/05, C08L 83/04, C08K 9/06, C08K 9/04, C08K 7/18, C09K 5/14

(54) **THERMALLY CONDUCTIVE SILICONE GREASE AND PREPARATION METHOD THEREFOR, AND CHIP ASSEMBLY**

(30) Priority: 14.04.2021 CN 202110400742
(71) Applicant: ZTE Corporation, Shenzhen, Guangdong 518057 (CN)
(72) Inventor: WANG, Jiaming, Shenzhen, Guangdong 518057 (CN); ZHENG, Jinqiao, Shenzhen, Guangdong 518057 (CN); LI, Shuai, Shenzhen, Guangdong 518057 (CN); LIU, Fan, Shenzhen, Guangdong 518057 (CN)
(74) Representative: Canzler & Bergmeier Patentanwälte Partnerschaft mbB
(86) International application number: PCT/CN2022/081360
(87) International publication number: WO 2022/218091

(57) **Abstract**

The present disclosure provides thermally conductive silicone grease, which is formed by uniformly mixing a plurality of raw material components, the plurality of raw material components comprising: 1 to 50 parts by mass of a base silicone oil; and 60 to 98 parts by mass of a thermally conductive filler; 0.02 to 1 part by mass of a silicone oil cross-linking agent. The present disclosure also provides a preparation method for thermally conductive silicone grease, and a chip assembly.

## Description

### TECHNICAL FIELD

The present disclosure relates to the technical field of thermal conductive interface material.

### BACKGROUND

A heat sink may be used to dissipate heat from a chip in an electronic product such as a communication product. In order to successfully transfer the heat generated by the chip to the heat sink, a thermal conductive layer made of a thermal conductive interface material such as thermal conductive silicone grease may be disposed at a contacting interface between the chip and the heat sink.

### SUMMARY

The present disclosure provides thermal conductive silicone grease, a preparation method thereof, and a chip assembly.

In a first aspect, an embodiment of the present disclosure provides thermal conductive silicone grease formed by uniformly mixing a plurality of raw material components, and the plurality of raw material components include: 1 to 50 parts by mass of basic silicone oil; 60 to 98 parts by mass of a thermal conductive filler; and 0.02 to 1 part by mass of a silicone-oil crosslinking agent.

According to an embodiment of the present disclosure, the silicone-oil crosslinking agent includes hydrogen-containing silicone oil.

According to an embodiment of the present disclosure, a mass percentage of hydrogen in the hydrogen-containing silicone oil is from 0.05% to 0.3%.

According to an embodiment of the present disclosure, the plurality of raw material components further include: 0.01 to 0.5 part by mass of a catalyst; and 0.001 to 0.5 part by mass of an inhibitor.

According to an embodiment of the present disclosure, the catalyst includes chloroplatinic acid; and the inhibitor includes any one or more of alkynol, polyvinyl silicone oil, maleate ester, organic amine, and a heavy-metal-ion compound.

According to an embodiment of the present disclosure, the thermal conductive filler includes: first spherical metal particles with a first particle size, which have a mass percentage of 40% to 60% in the thermal conductive filler, with the first particle size being between 5µm and 30µm; second spherical metal particles with a second particle size, which have a mass percentage of 20% to 30% in the thermal conductive filler, with the first particle size being between 1µm and 4µm; and spherical zinc oxide particles with a third particle size, which have a mass percentage of 10% to 30% in the thermal conductive filler, with the first particle size being between 0.1 µm and 0.5µm.

According to an embodiment of the present disclosure, the first spherical metal particles include any one or more of spherical aluminum particles and spherical silver particles, and the second spherical metal particles include any one or more of spherical aluminum particles and spherical silver particles.

According to an embodiment of the present disclosure, the basic silicone oil includes any one or more of dimethyl silicone oil, benzyl silicone oil, vinyl silicone oil, amino silicone oil, and methyl long-chain alkyl silicone oil.

According to an embodiment of the present disclosure, a viscosity of the basic silicone oil is between 30cps and 2000cps.

In a second aspect, an embodiment of the present disclosure provides a preparation method for thermal conductive silicone grease, including: uniformly mixing all raw material components of thermal conductive silicone grease to obtain the thermal conductive silicone grease; and the raw material components of the thermal conductive silicone grease include: 1 to 50 parts by mass of basic silicone oil; 60 to 98 parts by mass of a thermal conductive filler; and 0.02 to 1 part by mass of a silicone-oil crosslinking agent.

According to an embodiment of the present disclosure, the thermal conductive filler includes: first spherical metal particles with a first particle size, which have a mass percentage of 40% to 60% in the thermal conductive filler, with the first particle size being between 5µm and 30µm; second spherical metal particles with a second particle size, which have a mass percentage of 20% to 30% in the thermal conductive filler, with the first particle size being between 1µm and 4µm; and spherical zinc oxide particles with a third particle size, which have a mass percentage of 10% to 30% in the thermal conductive filler, with the first particle size being between 0.1 µm and 0.5µm.

According to an embodiment of the present disclosure, uniformly mixing all the raw material components of the thermal conductive silicone grease includes: adding the first spherical metal particles and the second spherical metal particles to the basic silicone oil, and stirring and dispersing to obtain a first intermediate product; adding the spherical zinc oxide particles to the first intermediate product, and stirring and dispersing to obtain a second intermediate product; and adding the silicone-oil crosslinking agent to the second intermediate product, and stirring and dispersing to form the thermal conductive silicone grease.

According to an embodiment of the present disclosure, uniformly mixing all the raw material components of the thermal conductive silicone grease includes: uniformly mixing all the raw material components of the thermal conductive silicone grease in a double planetary power mixer.

In a third aspect, an embodiment of the present disclosure provides a chip assembly, including: a chip; a heat sink; and a heat conduction layer filled between the chip and the heat sink, with the heat conduction layer formed by curing the thermal conductive silicone grease described in any one of the above embodiments.

### BRIEF DESCRIPTION OF DRAWINGS

In accompanying drawings for the embodiments of the present disclosure:
FIG. 1 is a flowchart of a preparation method for thermal conductive silicone grease according to an embodiment of the present disclosure;
FIG. 2 is a detailed flowchart of a preparation method for thermal conductive silicone grease according to an embodiment of the present disclosure; and
FIG. 3 is a detailed flowchart of a preparation method for thermal conductive silicone grease according to another embodiment of the present disclosure.

### DETAIL DESCRIPTION OF EMBODIMENTS

In order to enable those of ordinary skill in the art to better understand the technical solution of the present disclosure, thermal conductive silicone grease, a preparation method therefor, and a chip assembly provided by the embodiments of the present disclosure are described in detail below with reference to the accompanying drawings.

The present disclosure will be described more fully below with reference to the accompanying drawings, but the embodiments illustrated may be implemented in different forms, and the present disclosure should not be interpreted as being limited to the embodiments described below. Rather, the embodiments are provided to make the present disclosure thorough and complete, and are intended to enable those of ordinary skill in the art to fully understand the scope of the present disclosure.

The accompanying drawings for the embodiments of the present disclosure are intended to provide a further understanding of the embodiments of the present disclosure constitute a part of the description, and are used to explain the present disclosure together with specific embodiments of the present disclosure, but do not constitute any limitation to the present disclosure. The above and other features and advantages will become more apparent to those of ordinary skill in the art from the description of the specific embodiments with reference to the accompanying drawings.

All the embodiments of the present disclosure and the features therein may be combined with each other if no conflict is incurred.

Terms used herein are merely used to describe particular embodiments, and are not intended to limit the present disclosure. A term "and/or" used herein includes any and all combinations of one or more associated listed items. Terms "a" and "the" used herein which indicate a singular form are intended to include a plural form, unless expressly stated in the context. Terms "include" and "be made of" used herein indicate the presence of the described features, integers, steps, operations, elements and/or components, but do not exclude the presence or addition of one or more other features, integers, steps, operations, elements, components and/or combinations thereof.

Unless otherwise defined, all terms including technical and scientific terms used herein have the same meaning as commonly understood by those of ordinary skill in the art. It should be further understood that terms, such as those defined in commonly used dictionaries, should be interpreted as having a meaning that is consistent with a meaning in the context of the related technology and the background of the present disclosure, and should not be interpreted in an idealized or overly formal sense unless expressly so defined herein.

### Technical Terms

Unless otherwise specified, the following technical terms used in the embodiments of the present disclosure should be understood as having the following meanings:
Bonding Line Thickness (BLT), which represents a minimum adhesive thickness, i.e., a minimum thickness possible for a layer made of a thermal conductive material when the thermal conductive material is applied.

Coefficient of Thermal Expansion (CTE) mismatch, which represents a phenomenon that a relative deformation occurs due to different structures having different CTEs being heated.

Pump-out, which represents a phenomenon that a void is formed when the thermal conductive material is forced out from a chip and a heat sink.

@30psi, which represents that a corresponding piece of data is a value under "a pressure of 30 pounds per square inch".

Mass (weight) percentage of A in B, which refers to, with A being a part of B, a relative percentage of a mass of A in B when a total mass (including the mass of A) of B is taken as 100%.

Spherical metal particles/spherical zinc oxide particles, which means that shapes of metal particles and the zinc oxide particles used in a thermal conductive filler are generally spherical or approximately spherical, but does not mean that the specific shape of each of the particles is perfectly spherical.

### Specific Implementations

With the development of technologies such as the development of the 5G communication technology, power consumption of a chip is greatly increased, size and heat flux density of the chip are also increased, and a packaging method of the chip has developed from a 2D (two-dimensional) packaging method to a 2.5D even 3D (three-dimensional) packaging method, or developed from a packaged chip with a cover to a (unpackaged) bare-die chip. With the above changes, a deformation such as warpage of the chip becomes more and more severe.

With the increase of the heat flux density and the deformation of the chip, higher requirements are proposed on thermal performance and reliability of thermal conductive interface material used in the chip.

Thermal conductive silicone grease has advantages of low thermal resistance and low BLT, and being able to be applied to steel screen printing. Therefore, the thermal conductive silicone grease is used as the thermal conductive interface material between the chip and a heat sink in some related technologies. However, since some types of thermal conductive silicone grease do not have sufficient strength and are prone to deformation, when being used in a large-size and bare-die chip, the thermal conductive silicone grease may be faced with problems of pump-out and vertical flow (that is, the thermal conductive silicone grease flows out) in the presence of a deformation caused by the CTE mismatch between different structures, resulting in a failure to meet the requirement on the reliability.

In some other related technologies, a two-components thermal conductive gel is also used as a thermal conductive material. However, the two-components thermal conductive gel has a high viscosity and an excessive BLT which is usually greater than 0.2mm, and thus cannot meet requirements of a steel screen printing process. Moreover, the two-components thermal conductive gel has relatively high thermal resistance which is usually greater than 0.3°C·cm2/W@30psi, and thus can merely be used as a dispensing material, but cannot be used as the thermal conductive interface material between the chip and the heat sink, especially cannot be used for a ultra-thin thermal conductive layer of a large-size chip.

The embodiments of the present disclosure provide a type of thermal conductive silicone grease, which is formed by uniformly mixing a plurality of raw material components, which includes: 1 to 50 parts by mass of basic silicone oil, 60 to 98 parts by mass of a thermal conductive filler; and 0.02 to 1 part by mass of a silicone-oil crosslinking agent.

The thermal conductive silicone grease according to the embodiments of the present disclosure is made by uniformly mixing the plurality of raw material components, thus is not a "two-components" product, but is a single product as a whole. Moreover, since the raw material components of the thermal conductive silicone grease do not include a solvent, the thermal conductive silicone grease is a non-solvent-system product capable of being directly used.

The basic silicone oil is silicone oil used as a basic component in the thermal conductive silicone grease, the silicone-oil crosslinking agent can enable the basic silicone oil to be cross-linked, and the thermal conductive filler is a filler with a thermal conductive function.

The thermal conductive silicone grease according to the embodiments of the present disclosure is single-component thermal conductive silicone grease instead of a two-components thermal conductive gel, and does not include the solvent, so that the thermal conductive silicone grease has a low viscosity, good thixotropy, and a small BLT, and can be applied to the steel screen printing. Therefore, the thermal conductive silicone grease according to the embodiments of the present disclosure can be used as a thermal conductive interface material between the chip and the heat sink.

Since the thermal conductive silicone grease according to the embodiments of the present disclosure includes the silicone-oil crosslinking agent, after the thermal conductive silicone grease is cured, molecules of the basic silicone oil are not in a linear short chain form, but are cross-linked into a net form, which greatly improves strengths including a cohesive strength and a bonding strength. Thus, the problems of pump-out and vertical flow will not occur even in aging tests of the large-size and bare-die chip, so that the thermal conductive silicone grease has high reliability.

Through tests, performances of the thermal conductive silicone grease according to the embodiments of the present disclosure can achieve that a thermal conductive coefficient is greater than 5W/m.K (measured with the Hotdisk method), that thermal resistance is less than or equal to 0.07°C·cm2/W@30psi (measured according to the ASTM D5470 standard), that the BLT is less than or equal to 0.03mm@30psi (measured according to the ASTM D5470 standard), that an oil penetration rate is 0.01% (measured after being placed at 200°C for 24h), that volatile part by mass is 0.2% (measured after being placed at 200°C for 24h), that no pump-out or vertical flow occurs in an aging test (in which the thermal conductive silicone grease is applied to the large-size and bare-die chip and is measured after being circulated from -40°C to 125°C for 200 times), and that Shore hardness (Shore 00) measured after the aging test or after being baked at 125°C for 30min is from 30 to 70.

According to embodiments of the present disclosure, the silicone-oil crosslinking agent includes hydrogen-containing silicone oil.

According to embodiments of the present disclosure, a mass percentage of hydrogen in the hydrogen-containing silicone oil is from 0.05% to 0.3%.

According to embodiments of the present disclosure, the hydrogen-containing silicone oil (e.g., the hydrogen-containing silicone oil having the mass percentage of hydrogen of 0.05% to 0.3%) may be used as the silicone-oil crosslinking agent.

According to embodiments of the present disclosure, the hydrogen-containing silicone oil includes any one or more of hydrogen-containing-at-end silicone oil and hydrogen-containing-at-side silicone oil.

According to embodiments of the present disclosure, the raw material components further include: 0.01 to 0.5 part by mass of a catalyst, and 0.001 to 0.5 part by mass of an inhibitor.

According to embodiments of the present disclosure, the catalyst includes chloroplatinic acid, and the inhibitor includes any one or more of alkynol, polyvinyl silicone oil, maleate ester, organic amine, and a heavy-metal-ion compound.

According to embodiments of the present disclosure, a content of platinum in the chloroplatinic acid is from 1000ppm to 5000ppm.

In the case where the silicone-oil crosslinking agent is included, a crosslinking reaction may be accelerated by the catalyst, and an undesired reaction or excessively fast reaction may be avoided by the inhibitor.

According to embodiments of the present disclosure, a particle size of the thermal conductive filler is between 0.1µm and 50µm.

According to embodiments of the present disclosure, the thermal conductive filler includes spherical metal particles with a first particle size, which have a mass percentage of 40% to 60% in the thermal conductive filler, with the first particle size being between 5µm and 30µm, spherical metal particles with a second particle size, which have a mass percentage of 20% to 30% in the thermal conductive filler, with the second particle size being between 1µm and 4µm, and spherical zinc oxide particles with a third particle size, which have a mass percentage of 10% to 30% in the thermal conductive filler, with the third particle size being between 0.1µm and 0.5µm.

The thermal conductive filler according to the embodiments of the present disclosure includes three types of spherical particles having the specific particle sizes and made of specific materials, namely the spherical metal particles having the particle size of 5µm to 30µm and the mass percentage of 40wt% to 60wt%, the spherical metal particles having the particle size of 1µm to 4µm and the mass percentage of 20wt% to 30wt%, and the spherical zinc oxide particles having the particle size of 0.1 µm to 0.5µm and the mass percentage of 10wt% to 30wt%.

By using the thermal conductive filler including the spherical particles which have the specific particle sizes and are made of the specific materials, the thermal resistance of the thermal conductive silicone grease according to the embodiments of the present disclosure may be further reduced, and the thermal conductive performance (such as a K value) of the thermal conductive silicone grease may be improved, so that the thermal conductive silicone grease may meet heat dissipation requirements of the large-size and high-power-consumption chip.

According to embodiments of the present disclosure, the spherical metal particles include any one or more of spherical aluminum particles and spherical silver particles.

The spherical metal particles according to the embodiments of the present disclosure may be selected from the spherical aluminum particles (aluminum powder) and the spherical silver particles (silver powder). For example, the spherical metal particles may be the spherical aluminum particles (the aluminum powder), because a cost of the spherical aluminum particles is relatively low, and electrical conductivity of the spherical aluminum particles is not too high due to a very thin aluminum oxide layer formed on surfaces of the spherical aluminum particles.

According to embodiments of the present disclosure, in addition to the above spherical particles having the specific particle sizes and made of the specific materials, the thermal conductive filler may further include: any one or more of magnesium oxide particles, aluminum nitride particles, silicon nitride particles, boron nitride particles, carbon fibers, diamond particles, and copper powder, particle sizes of which may be from 0.1µm to 50µm

According to embodiments of the present disclosure, the raw material components further include 0.01 to 10 parts by mass of a filler treating agent.

According to embodiments of the present disclosure, the filler treating agent includes any one or more of a silane coupling agent, stearic acid, titanate ester, and aluminate ester.

According to embodiments of the present disclosure, the use of the filler treating agent may improve distribution of the thermal conductive filler.

According to embodiments of the present disclosure, the basic silicone oil includes one or more of dimethyl silicone oil, benzyl silicone oil, vinyl silicone oil, amino silicone oil, and methyl long-chain alkyl silicone oil.

According to embodiments of the present disclosure, a viscosity of the basic silicone oil is between 30cps and 2000cps.

According to the embodiments of the present disclosure, the selection of the components and the viscosity of the basic silicone oil may ensure that the whole thermal conductive silicone grease has a low viscosity and good thixotropy, so that the thermal conductive silicone grease may be applied to the steel screen printing and may have the low BLT.

According to embodiments of the present disclosure, the raw material components further include any one or more of a color paste, a flame retardant, a thixotropic agent, and a tackifier (such as a tackifying resin).

In addition to the above described raw material components, the raw material components may further include various conventional additives as described above, which are not described in detail here.

The embodiments of the present disclosure provide a preparation method for the thermal conductive silicone grease.

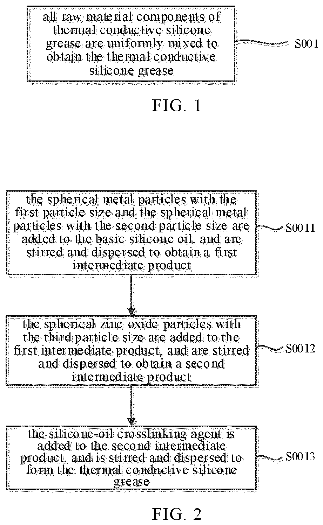

FIG. 1 is a flowchart of the preparation method for the thermal conductive silicone grease according to embodiments of the present disclosure. Referring to FIG. 1, the preparation method according to the embodiments of the present disclosure includes steps S001.

In the step S001, all raw material components of the thermal conductive silicone grease are uniformly mixed to obtain the thermal conductive silicone grease.

The raw material components of the thermal conductive silicone grease include 1 to 50 parts by mass of the basic silicone oil, 60 to 98 parts by mass of the thermal conductive filler, and 0.02 to 1 part by mass of the silicone-oil crosslinking agent.

According to embodiments of the present disclosure, the thermal conductive filler includes the spherical metal particles with the first particle size, which have the mass percentage of 40% to 60% in the thermal conductive filler, with the first particle size being between 5µm and 30µm, the spherical metal particles with the second particle size, which have the mass percentage of 20% to 30% in the thermal conductive filler, with the first particle size being between 1µm and 4µm, and the spherical zinc oxide particles with the third particle size, which have the mass percentage of 10% to 30% in the thermal conductive filler, with the first particle size being between 0.1µm and 0.5µm.

The preparation method according to the embodiments of the present disclosure is used for preparing the above thermal conductive silicone grease, and the raw material components need to be uniformly mixed according to the preparation method.

FIG. 2 is a detailed flowchart of the preparation method for the thermal conductive silicone grease according to embodiments of the present disclosure. The detailed flowchart shown in FIG. 2 illustrates a detailed process of the step S001 shown in FIG. 1. Referring to FIG. 2, uniformly mixing all the raw material components of the thermal conductive silicone grease (the step S001) includes steps S0011 to S0013.

In the step S0011, the spherical metal particles with the first particle size and the spherical metal particles with the second particle size are added to the basic silicone oil, and are stirred and dispersed to obtain a first intermediate product.

In the step S0012, the spherical zinc oxide particles with the third particle size are added to the first intermediate product obtained in the step S0011, and are stirred and dispersed to obtain a second intermediate product.

In the step S0013, the silicone-oil crosslinking agent is added to the second intermediate product obtained in the step S0012, and is stirred and dispersed to form the thermal conductive silicone grease.

According to the embodiments of the present disclosure, when the above raw material components are mixed, the basic silicone oil (may further include the filler treating agent) may be used as a base, the spherical metal particles are firstly added to the base, and are stirred and dispersed, the spherical zinc oxide particles are then added, and are stirred and dispersed, and the silicone-oil crosslinking agent (may further include the inhibitor) is then added, and finally, if needed, the catalyst may also be added.

According to embodiments of the present disclosure, uniformly mixing all the raw material components of the thermal conductive silicone grease (the step S001) includes: uniformly mixing all the raw material components of the thermal conductive silicone grease in a double planetary power mixer. In the present disclosure, the double planetary power mixer is merely an example, and the present disclosure is not limited thereto, any device capable of uniformly mixing all the raw material components may be used.

According to the embodiments of the present disclosure, the double planetary power mixer may be used to mix all the above raw material components, so that the preparation of the thermal conductive silicone grease may be carried out in one device, e.g., the double planetary power mixer, without using a plurality of devices (such as a grinder and a vacuum kneader). Thus, the preparation process of the thermal conductive silicone grease is simple, and is low in cost.

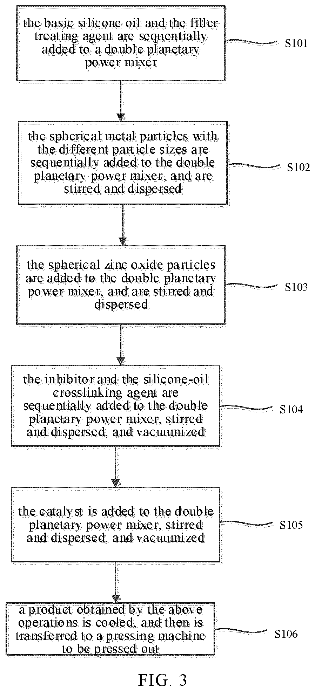

FIG. 3 is a flowchart of a preparation method for thermal conductive silicone grease according to another embodiment of the present disclosure. Referring to FIG. 3, the preparation method for the thermal conductive silicone grease according to the embodiments of the present disclosure may include steps S101 to S106.

In step S101, the basic silicone oil and the filler treating agent are sequentially added to the double planetary power mixer.

In step S102, the spherical metal particles (the thermal conductive filler) with the different particle sizes are sequentially added to the double planetary power mixer, and are stirred and dispersed. Time for the stirring is from 10min to 60min, a stirring speed is from 20r/min to 50r/min, and a dispersion speed is from 350r/min to 900r/min.

In step S103, the spherical zinc oxide particles (the thermal conductive filler) are added to the double planetary power mixer, and are stirred and dispersed. Time for the stirring and the dispersion is from 10min to 60min, a stirring speed is from 20r/min to 50r/min, and a dispersion speed is from 350r/min to 900r/min.

In step S104, the above described inhibitor and the silicone-oil crosslinking agent are sequentially added to the double planetary power mixer, stirred and dispersed, and vacuumized. Time for the stirring and the dispersion is from 10min to 60min, a stirring speed is from 20r/min to 50r/min, and a dispersion speed is from 350r/min to 900r/min, and a vacuum degree is from -0.096MPa to -0.1MPa.

In step S105, the above described catalyst is added to the double planetary power mixer, stirred and dispersed, and vacuumized. Time for the stirring and the dispersion is from 10min to 60min, a stirring speed is from 20r/min to 50r/min, and a dispersion speed is from 350r/min to 900r/min, and a vacuum degree is from -0.096MPa to -0.1MPa.

In step S106, a product obtained by the above steps is cooled, and then is transferred to a pressing machine to be pressed out. Thus, the thermal conductive silicone grease according to the embodiments of the present disclosure is formed.

The embodiments of the present disclosure provide a chip assembly, which includes: a chip; a heat sink; and a thermal conductive layer filled between the chip and the heat sink and formed by curing any thermal conductive silicone grease described above.

The chip assembly according to the embodiments of the present disclosure includes the chip and the heat sink, and the thermal conductive layer formed by curing the above-described thermal conductive silicone grease is provided between the chip and the heat sink.

The chip assembly according to the embodiments of the present disclosure has various application types and various forms.

For example, the chip assembly may be a carrier device chip, a fixed-network chip, a server chip, a computer chip, or the like.

For example, the forms of the chip assembly may be as follows: (1) a spring-screw heat sink/a push-in heat sink and a bare-die chip/a chip with a cover; and (2) a chip and a screw-fastened hard-contact housing (the heat sink).

The chip assembly may be in a form of "a large-size and high-power-consumption chip and an ultra-thin thermal conductive layer".

According to embodiments of the present disclosure, for example, the raw material components for preparing the thermal conductive silicone grease may include: 6 parts by mass of the basic silicone oil which is vinyl silicone oil and has a viscosity of 100cps; 85 parts by mass of the thermal conductive filler which consists of the spherical aluminum particles with the particle size of 10µm, the spherical aluminum particles with the particle size of 2µm, and the spherical zinc oxide particles with the particle size of 0.3µm, with mass percentages of the spherical aluminum particles with the particle size of 10µm, the spherical aluminum particles with the particle size of 2µm, and the spherical zinc oxide particles with the particle size of 0.3µm being 50%, 28%, and 22% respectively; 0.2 part by mass of the filler treating agent which is octyl trimethoxy siloxane (the silane coupling agent); 0.35 part by mass of the silicone-oil crosslinking agent which is a mixture of the hydrogen-containing-at-end silicone oil and the hydrogen-containing-at-side silicone oil, with a mass percentage of hydrogen in the mixture being 0.1% and a mass ratio of the hydrogen containing-at-end silicone oil to the hydrogen-containing-at-side silicone oil being 1:2.5; 0.1 part by mass of the catalyst which is chloroplatinic acid having a mass content of platinum of 3000ppm; and 0.01 part by mass of the inhibitor which is acetylene cyclohexanol.

According to embodiments of the present disclosure, for example, the preparation method for the thermal conductive silicone grease may include: in step A101, sequentially adding the basic silicone oil and the filler treating agent to the double planetary power mixer; in step A102, sequentially adding the spherical aluminum particles with the particle size of 10µm and the spherical aluminum particles with the particle size of 2µm to the double planetary power mixer, and stirring and dispersing for 15min at a stirring speed of 25r/min and a dispersion speed of 600r/min; in step A103, sequentially adding the spherical zinc oxide particles with the particle size of 0.3µm to the double planetary power mixer, and stirring and dispersing for 30min at the stirring speed of 25r/min and the dispersing speed of 600r/min; in step A104, sequentially adding the inhibitor and the silicone-oil crosslinking agent to the double planetary power mixer, and stirring, dispersing, and vacuumizing for 15min at the stirring speed of 25r/min and the dispersing speed of 600r/min and with a vacuum degree of -0.097MPa; in step A105, adding the catalyst to the double planetary power mixer, and stirring, dispersing, and vacuumizing for 30min at the stirring speed of 25r/min and the dispersing speed of 600r/min and with the vacuum degree of -0.097MPa; and in step A106, transferring a product obtained by the above operations to a pressing machine, and pressing the product into a can to obtain a sample of the thermal conductive silicone grease according to the present example.

After the sample of the thermal conductive silicone grease prepared by the above steps A101 to A106 is subjected to performance tests, the following results are obtained: the thermal conductive coefficient: 5.5W/m.K (measured with the Hotdisk method); the thermal resistance: 0.05°C·cm2/W@30psi (measured according to the ASTM D5470 standard); the BLT: 0.02mm@30psi (measured according to the ASTM D5470 standard); the oil penetration rate: 0.01% (measured after being placed at 200°C for 24h); the volatile part by mass: 0.2% (measured after being placed at 200°C for 24h); the aging test (in which the thermal conductive silicone grease is used in the large-size and bare-die chip and is measured after being circulated from -40°C to 125°C for 200 times): no pump-out or vertical flow; and the Shore hardness (Shore 00) (measured after being baked at 125°C for 30min): 40.

According to embodiments of the present disclosure, for example, the raw material components for preparing the thermal conductive silicone grease may include: 6 parts by mass of the basic silicone oil which is dimethyl silicone oil and has a viscosity of 1800cps; 95 parts by mass of the thermal conductive filler which consists of the spherical aluminum particles with the particle size of 25µm, the spherical aluminum particles with the particle size of 1µm, and the spherical zinc oxide particles with the particle size of 0.5µm, with mass percentages of the spherical aluminum particles with the particle size of 25µm, the spherical aluminum particles with the particle size of 1µm, and the spherical zinc oxide particles with the particle size of 0.5µm being 40%, 30%, and 30% respectively; 3 parts by mass of the filler treating agent which is titanate ester; 1 part by mass of the silicone-oil crosslinking agent which is a mixture of the hydrogen containing-at-end silicone oil and the hydrogen-containing-at-side silicone oil, with a mass percentage of hydrogen in the mixture being 0.2% and a mass ratio of the hydrogen containing-at-end silicone oil to the hydrogen-containing-at-side silicone oil being 1:1; 0.01 part by mass of the catalyst which is chloroplatinic acid having a mass content of platinum of 5000ppm; and 0.001 part by mass of the inhibitor which is maleate ester.

According to embodiments of the present disclosure, for example, the preparation method for the thermal conductive silicone grease may include: in step A201, sequentially adding the basic silicone oil and the filler treating agent to the double planetary power mixer; in step A202, sequentially adding the spherical aluminum particles with the particle size of 25µm and the spherical aluminum particles with the particle size of 1µm to the double planetary power mixer, and stirring and dispersing for 10min at a stirring speed of 50r/min and a dispersion speed of 900r/min; in step A203, sequentially adding the spherical zinc oxide particles with the particle size of 0.5µm to the double planetary power mixer, and stirring and dispersing for 10min at the stirring speed of 50r/min and the dispersion speed of 900r/min; in step A204, sequentially adding the inhibitor and the silicone-oil crosslinking agent to the double planetary power mixer, and stirring, dispersing, and vacuumizing for 20min at the stirring speed of 50r/min and the dispersion speed of 900r/min and with a vacuum degree of -0.1MPa; in step A205, adding the catalyst to the double planetary power mixer, and stirring, dispersing, and vacuumizing for 20min at the stirring speed of 50r/min and the dispersion speed of 900r/min and with the vacuum degree of -0.1MPa; and in step A206, transferring a product obtained by the above operations to a pressing machine, and pressing the product into a can to obtain a sample of the thermal conductive silicone grease according to the present example.

After the sample of the thermal conductive silicone grease prepared by the above steps A201 to A206 is subjected to performance tests, the following results are obtained: the thermal conductive coefficient: 5.9W/m.K (measured with the Hotdisk method); the thermal resistance: 0.05°C·cm2/W@30psi (measured according to the ASTM D5470 standard); the BLT: 0.03mm@30psi (measured according to the ASTM D5470 standard); the oil penetration rate: 0.01% (measured after being placed at 200°C for 24h); the volatile part by mass: 0.2% (measured after being placed at 200°C for 24h); the aging test (in which the thermal conductive silicone grease is used in the large-size and bare-die chip and is measured after being circulated from -40°C to 125°C for 200 times): no pump-out or vertical flow; and the Shore hardness (Shore 00) (measured after being baked at 125°C for 30min): 70.

According to embodiments of the present disclosure, for example, the raw material components for preparing the thermal conductive silicone grease may include: 45 parts by mass of the basic silicone oil which is dimethyl silicone oil and has a viscosity of 300cps; 60 parts by mass of the thermal conductive filler which consists of the spherical aluminum particles with the particle size of 20µm, the spherical aluminum particles with the particle size of 4µm, and the spherical zinc oxide particles with the particle size of 0.5µm, with mass percentages of the spherical aluminum particles with the particle size of 25µm, the spherical aluminum particles with the particle size of 1µm, and the spherical zinc oxide particles with the particle size of 0.1µm being 60%, 20%, and 20% respectively; 8 parts by mass of the filler treating agent which is aluminate ester; 0.5 part by mass of the silicone-oil crosslinking agent which is a mixture of the hydrogen-containing-at-end silicone oil and the hydrogen-containing-at-side silicone oil, with a mass percentage of hydrogen in the mixture being 0.3% and a mass ratio of the hydrogen-containing-at-end silicone oil to the hydrogen-containing-at-side silicone oil being 1:0.8; 0.5 part by mass of the catalyst which is chloroplatinic acid having a mass content of platinum of 1000ppm; and 0.5 part by mass of the inhibitor which is polyvinyl silicone oil.

According to embodiments of the present disclosure, for example, the preparation method for the thermal conductive silicone grease may include: in step A301, sequentially adding the basic silicone oil and the filler treating agent to the double planetary power mixer; in step A302, sequentially adding the spherical aluminum particles with the particle size of 20µm and the spherical aluminum particles with the particle size of 4µm to the double planetary power mixer, and stirring and dispersing for 50min at a stirring speed of 20r/min and a dispersion speed of 400r/min; in step A303, sequentially adding the spherical zinc oxide particles with the particle size of 0.1µm to the double planetary power mixer, and stirring and dispersing for 45min at the stirring speed of 20r/min and the dispersion speed of 400r/min; in step A304, sequentially adding the inhibitor and the silicone-oil crosslinking agent to the double planetary power mixer, and stirring, dispersing, and vacuumizing for 45min at the stirring speed of 20r/min and the dispersion speed of 400r/min and with a vacuum degree of -0.1MPa; in step A305, adding the catalyst to the double planetary power mixer, and stirring, dispersing, and vacuumizing for 50min at the stirring speed of 20r/min and the dispersion speed of 400r/min and with the vacuum degree of -0.1MPa; and in step A306, transferring a product obtained by the above operations to a pressing machine, and pressing the product into a can to obtain a sample of the thermal conductive silicone grease according to the present example.

After the sample of the thermal conductive silicone grease prepared by the above steps A301 to A306 is subjected to performance tests, the following results are obtained: the thermal conductive coefficient: 5.2W/m.K (measured with the Hotdisk method); the thermal resistance: 0.07°C·cm2/W@30psi (measured according to the ASTM D5470 standard); the BLT: 0.02mm@30psi (measured according to the ASTM D5470 standard); the oil penetration rate: 0.01% (measured after being placed at 200°C for 24h); the volatile part by mass: 0.2% (measured after being placed at 200°C for 24h); the aging test (in which the thermal conductive silicone grease is used in the large-size and bare-die chip and is measured after being circulated from -40°C to 125°C for 200 times): no pump-out or vertical flow; and the Shore hardness (Shore 00) (measured after being baked at 125°C for 30min): 55.

The present disclosure has disclosed the exemplary embodiments using specific terms, but the terms are merely used and should be merely interpreted as having general illustrative meanings, rather than for the purpose of limitation. Unless expressly stated, it is apparent to those of ordinary skill in the art that features, characteristics and/or elements described in connection with a particular embodiment may be used alone or in combination with features, characteristics and/or elements described in connection with other embodiments. Therefore, it should be understood by those of ordinary skill in the art that various changes in the forms and the details may be made without departing from the scope of the present disclosure of the appended claims.

## Claims

1. Thermal conductive silicone grease formed by uniformly mixing a plurality of raw material components, wherein the plurality of raw material components comprises:
1 to 50 parts by mass of basic silicone oil;
60 to 98 parts by mass of a thermal conductive filler; and
0.02 to 1 part by mass of a silicone-oil crosslinking agent.

2. The thermal conductive silicone grease of claim 1, wherein
the silicone-oil crosslinking agent comprises hydrogen-containing silicone oil.

3. The thermal conductive silicone grease of claim 2, wherein
a mass percentage of hydrogen in the hydrogen-containing silicone oil is from 0.05% to 0.3%.

4. The thermal conductive silicone grease of claim 1, wherein the plurality of raw material components further comprise:
0.01 to 0.5 part by mass of a catalyst; and
0.001 to 0.5 part by mass of an inhibitor.

5. The thermal conductive silicone grease of claim 4, wherein
the catalyst comprises chloroplatinic acid; and
the inhibitor comprises any one or more of alkynol, polyvinyl silicone oil, maleate ester, organic amine, and a heavy-metal-ion compound.

6. The thermal conductive silicone grease of claim 1, wherein the thermal conductive filler comprises:
first spherical metal particles with a first particle size, which have a mass percentage of 40% to 60% in the thermal conductive filler, with the first particle size being between 5µm and 30µm;
second spherical metal particles with a second particle size, which have a mass percentage of 20% to 30% in the thermal conductive filler, with the first particle size being between 1µm and 4µm; and
spherical zinc oxide particles with a third particle size, which have a mass percentage of 10% to 30% in the thermal conductive filler, with the first particle size being between 0.1µm and 0.5µm.

7. The thermal conductive silicone grease of claim 6, wherein
the first spherical metal particles comprise any one or more of spherical aluminum particles and spherical silver particles, and the second spherical metal particles comprise any one or more of spherical aluminum particles and spherical silver particles.

8. The thermal conductive silicone grease of claim 1, wherein
the basic silicone oil comprises any one or more of dimethyl silicone oil, benzyl silicone oil, vinyl silicone oil, amino silicone oil, and methyl long-chain alkyl silicone oil.

9. The thermal conductive silicone grease of claim 1, wherein
a viscosity of the basic silicone oil is between 30cps and 2000cps.

10. A preparation method for thermal conductive silicone grease, comprising:
uniformly mixing all raw material components of thermal conductive silicone grease to obtain the thermal conductive silicone grease,
wherein the raw material components of the thermal conductive silicone grease comprise:
1 to 50 parts by mass of basic silicone oil;
60 to 98 parts by mass of a thermal conductive filler; and
0.02 to 1 part by mass of a silicone-oil crosslinking agent.

11. The preparation method of claim 10, wherein the thermal conductive filler comprises:
first spherical metal particles with a first particle size, which have a mass percentage of 40% to 60% in the thermal conductive filler, with the first particle size being between 5µm and 30µm;
second spherical metal particles with a second particle size, which have a mass percentage of 20% to 30% in the thermal conductive filler, with the first particle size being between 1µm and 4µm; and
spherical zinc oxide particles with a third particle size, which have a mass percentage of 10% to 30% in the thermal conductive filler, with the first particle size being between 0.1µm and 0.5µm.

12. The preparation method of claim 11, wherein uniformly mixing all the raw material components of the thermal conductive silicone grease comprises:
adding the first spherical metal particles and the second spherical metal particles to the basic silicone oil, and stirring and dispersing to obtain a first intermediate product;
adding the spherical zinc oxide particles to the first intermediate product, and stirring and dispersing to obtain a second intermediate product; and
adding the silicone-oil crosslinking agent to the second intermediate product, and stirring and dispersing to form the thermal conductive silicone grease.

13. The preparation method of any one of claims 10 to 12, wherein uniformly mixing all the raw material components of the thermal conductive silicone grease comprises:
uniformly mixing all the raw material components of the thermal conductive silicone grease in a double planetary power mixer.

14. A chip assembly, comprising:
a chip;
a heat sink; and
a heat conduction layer filled between the chip and the heat sink, with the heat conduction layer formed by curing the thermal conductive silicone grease of any one of claims 1 to 9.
